(19) Europäisches Patentamt / European Patent Office / Office européen des brevets

(11) **EP 2 660 778 A1**

(12) **DEMANDE DE BREVET EUROPEEN**

(43) Date de publication:
**06.11.2013 Bulletin 2013/45**

(51) Int Cl.:
***G06T 7/00*** (2006.01)

(21) Numéro de dépôt: **13166025.0**

(22) Date de dépôt: **30.04.2013**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **04.05.2012 FR 1254130**

(71) Demandeur: **COMMISSARIAT A L'ENERGIE ATOMIQUE ET AUX ENERGIES ALTERNATIVES 75015 Paris (FR)**

(72) Inventeurs:
• **Foucher, Johann**
  **38340 Voreppe (FR)**
• **Saied, Mazen**
  **38240 Meylan (FR)**

(74) Mandataire: **Lebkiri, Alexandre**
  **Cabinet Camus Lebkiri**
  **87 Rue Taitbout**
  **75009 Paris (FR)**

(54) **Procédé de détermination d'un seuil applicable pour déterminer la dimension critique d'au moins une catégorie de motifs imagés par microscopie électronique à force atomique à balayage**

(57)    L'invention concerne un procédé de détermination d'un seuil applicable pour déterminer la dimension critique (CD) d'une catégorie de motifs (M) imagés par microscopie électronique à force atomique à balayage, ledit procédé comportant les étapes suivantes :

- à partir d'une pluralité de motifs (M), acquisition (101) d'un couple d'images (IM1, IM2) pour chaque motif (M) :

o une première image (IM1) étant obtenue au moyen d'une instrumentation d'imagerie mettant en oeuvre la technique de microscopie électronique à force atomique à balayage, dite instrumentation CD-SEM, dont on cherche à déterminer ledit seuil ;

o une deuxième image (IM2) étant obtenue au moyen d'une instrumentation de référence mettant en oeuvre une technique différente de ladite technique CD-SEM ;

o pour chaque couple d'images (IM1, IM2) : détermination (102) d'une dimension critique ($CD_{REF}$) de référence via l'image (IM2) obtenue au moyen de ladite instrumentation de référence et détermination (103) d'un seuil empirique ($S_{EMP}$) applicable à l'image (IM1) obtenue au moyen de ladite instrumentation CD-SEM de sorte que ledit seuil empirique ($S_{EMP}$) corresponde sensiblement à ladite dimension critique de référence ($CD_{REF}$);

- détermination (104) du seuil (S) applicable à une catégorie de motifs (M), ledit seuil (S) étant déterminé à partir d'une pluralité de seuils empiriques ($S_{EMP}$).

Fig. 2

**Description**

La présente invention concerne le domaine de la métrologie et a pour objet un procédé de détermination d'un seuil optimisé applicable pour déterminer la dimension critique d'au moins une catégorie de motifs imagés par microscopie électronique à force atomique à balayage. Ce seuil ainsi déterminé peut être ensuite utilisé en production pour caractériser des motifs, notamment ceux utilisés dans les circuits intégrés microélectroniques.

En microélectronique, les progrès de la technologie s'accompagnent de besoins en instruments de caractérisation. Pour chaque noeud technologique, les outils de métrologie doivent être de plus en plus performants en étant capables d'assurer le contrôle dimensionnel des dispositifs fabriqués.

Pour ce faire, l'industrie des semi-conducteurs définit et suit les dimensions des produits fabriqués à l'aide de ce que l'on appelle le CD (« Critical Dimension » en anglais) ou Dimension Critique. La diminution permanente de la dimension critique des circuits implique l'adaptation correspondante des méthodes de mesure. Simultanément, l'augmentation de la taille des galettes (ou wafer en anglais) et les coûts représentés par chacune d'elles impliquent le contrôle et la détection des défauts en production.

L'un des problèmes de cette notion de Dimension Critique CD réside dans sa définition même qui peut varier selon le type de motifs étudiés ; ainsi, dans le cas de trous ou de plots, le CD sera le diamètre ; s'il s'agit d'une ligne ou d'une tranchée, le CD sera la largeur de la ligne ou de la tranchée.

Outre la définition même du CD, la position verticale de sa mesure varie selon les motifs à caractériser. Ainsi, le CD d'une grille de transistor sera plutôt mesuré le plus bas possible tandis que les CD d'un contact de grille ou d'une ligne d'interconnexion seront plutôt mesurés le plus haut possible.

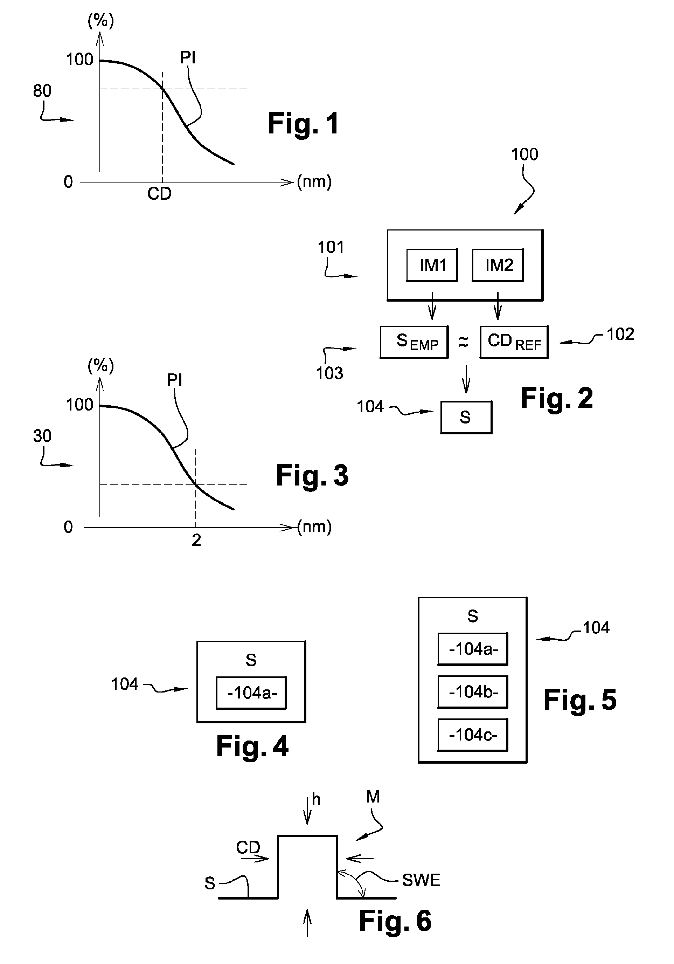

Pour réaliser la mesure d'un CD par CD-SEM, on émet un faisceau d'électrons primaires à la surface du motif à analyser qui, en réponse, réémet des électrons secondaires. Ces électrons secondaires sont analysés par des détecteurs qui permettent de reconstruire un graphique comme illustré sur la figure 1 représentant un profil d'intensité d'électrons secondaires PI comportant en ordonnées un pourcentage d'électrons secondaires recueillis et en abscisse une dimension en nm représentative du CD. Actuellement, on estime, souvent à tort, qu'un seuil d'électrons secondaires obtenu empiriquement, par exemple de 80%, est applicable à tout type de motif. Ainsi, on applique le seuil de 80% et on en déduit la dimension critique mesurée quel que soit le type de motif analysé.

Un seuil fixe empirique appliqué à tout type de motif est d'autant moins satisfaisant qu'il n'y a aucun lien physique entre le pourcentage d'électrons secondaires recueillis et la hauteur réelle du motif à laquelle on cherche à déterminer la dimension critique. En d'autres termes, si une mesure à 80% d'électrons secondaires est réalisée, ce n'est pas pour autant que l'on mesure une dimension critique à 80% de la hauteur du motif.

Dans ce contexte, la présente invention a pour but de fournir un procédé de détermination d'un seuil applicable pour déterminer la dimension critique d'au moins une catégorie de motifs imagés par microscopie électronique à force atomique à balayage utilisable aussi bien en recherche et développement qu'en production, permettant de donner une valeur plus précise et plus réaliste de la dimension critique recherchée quel que soit le niveau de fabrication à caractériser (par exemple niveau lithographie ou niveau gravure).

A cette fin, l'invention concerne un procédé de détermination d'un seuil applicable pour déterminer la dimension critique d'au moins une catégorie de motifs imagés par microscopie électronique à force atomique à balayage, ledit procédé comportant les étapes suivantes :

- à partir d'une pluralité de motifs, acquisition d'un couple d'images pour chaque motif :

  ○ une première image étant obtenue au moyen d'une instrumentation d'imagerie mettant en oeuvre la technique de microscopie électronique à force atomique à balayage, dite instrumentation CD-SEM, dont on cherche à déterminer ledit seuil ;
  ○ une deuxième image étant obtenue au moyen d'une instrumentation d'imagerie de référence mettant en oeuvre une technique différente de ladite technique de microscopie électronique à balayage ;
  ○ pour chaque couple d'images obtenu pour chacun des motifs :

    ■ détermination d'une dimension critique de référence via l'image obtenue au moyen de ladite instrumentation d'imagerie de référence ;
    ■ détermination d'un seuil empirique applicable à l'image obtenue au moyen de ladite instrumentation CD-SEM de sorte que ledit seuil empirique corresponde sensiblement à ladite dimension critique de référence;

- détermination du seuil applicable à au moins une catégorie de motifs, ledit seuil étant déterminé à partir d'une pluralité de seuils empiriques, chaque seuil empirique correspondant à un couple d'images.

Le procédé selon l'invention propose, contrairement à la métrologie CD actuelle, de déterminer un seuil (applicable pour au moins une catégorie de motifs) se rapprochant sensiblement du seuil réel correspondant à la hauteur au niveau de laquelle se situe la dimension critique que l'on souhaite mesurer.

On entend par seuil un pourcentage d'électrons secondaires réémis par un motif soumis à un faisceau d'électrons primaires lors d'une mesure CD-SEM.

Suivant la précision recherchée, il est possible de déterminer ce seuil pour :

- une unique catégorie de motifs ; dans ce cas, le seuil est déterminé de sorte qu'il corresponde sensiblement à la hauteur (i.e. la position verticale) au niveau de laquelle se situe le CD sur le motif ;
- une pluralité de catégories de motifs, voire à tout type de motifs ; dans ce cas, le seuil déterminé est ajusté de sorte qu'il soit applicable à la pluralité de catégories de motifs et ce quelle que soit la hauteur au niveau de laquelle se situe chacun des CD des différentes catégories de motifs.

On entend par dimension critique, la ou les Dimensions Critiques d'un motif représentant une ou plusieurs longueurs caractéristiques du motif qui s'avèrent critiques soit pour la maitrise du procédé de fabrication soit pour garantir les performances électriques du dispositif électronique final constitué des dits motifs.

- La dimension critique varie selon le type de motifs étudiés ; ainsi, dans le cas de trous ou de plots, la dimension critique sera le diamètre ; s'il s'agit d'une ligne ou d'une tranchée, la dimension critique sera la largeur de la ligne ou de la tranchée.

Le procédé selon l'invention peut également présenter une ou plusieurs des caractéristiques ci-dessous, considérées individuellement ou selon toutes les combinaisons techniquement possibles :

- le seuil est un seuil constant applicable à toutes les catégories de motifs ; avantageusement, on utilisera un seuil constant pour des motifs identiques, par exemple des motifs identiques mesurés sur une plaquette de production ; si le CD varie, il y aura alors une vraie variation de dimensions sur la plaquette ;
- le seuil constant est déterminé en minimisant l'écart entre le seuil constant et chacun des seuils empiriques ;
- l'écart entre le seuil constant et chacun des seuils empiriques est minimisé en utilisant une méthode consistant à minimiser l'erreur quadratique RMS ;
- le seuil est un seuil variable fonction de la catégorie de motifs ; si on travaille par exemple sur une plaquette de lithographie possédant une matrice expo-focus (matrice FEM ou « Focus Exposure Matrix »), il peut y avoir des variations géométriques en 2 dimensions (CD, hauteur, angle). Dans ce cas, l'utilisation d'un seuil variable peut être utile car il permet de prendre en compte des variations géométriques multiples ;
- le seuil variable est déterminé en :

  ○ calculant un seuil variable empirique pour chaque image de référence d'une même catégorie de motifs, n images étant réalisées sur m motifs de ladite même catégorie ;
  ○ minimisant l'écart entre le seuil variable et chacun des seuils variables empiriques calculés ;

- chaque seuil variable empirique est une fonction de la dimension critique de référence de la catégorie de motifs, d'une hauteur de référence et/ou d'un angle de référence de ladite catégorie de motifs ;
- ladite fonction est un polynôme de second degré ;
- le polynôme de second degré comporte un coefficient constant égal au seuil constant ;
- l'écart entre le seuil variable et chacun des seuils variables empiriques est minimisé en utilisant une méthode consistant à minimiser l'erreur quadratique RMS ;
- l'instrumentation d'imagerie de référence met en oeuvre l'une des techniques suivantes :

  ○ microscopie à force atomique en trois dimensions, ou
  ○ microscopie électronique en transmission.

D'autres caractéristiques et avantages de l'invention ressortiront clairement de la description qui en est donnée ci-dessous, à titre indicatif et nullement limitatif, en référence aux figures annexées, parmi lesquelles :

- la figure 1 illustre schématiquement un profil d'intensité d'électrons secondaires en fonction du profil d'un motif obtenu via la technique CD-SEM ;
- la figure 2 représente les différentes étapes du procédé selon l'invention ;
- la figure 3 illustre le principe de l'étape de détermination d'un seuil empirique,
- la figure 4 illustre un premier mode de réalisation du procédé illustré sur la figure 2 ;

- la figure 5 illustre un second mode de réalisation du procédé illustré en figure 2 ;
- la figure 6 représente de façon schématique un motif ainsi que différents paramètres dimensionnels de ce motif.

La figure 2 illustre schématiquement les différentes étapes du procédé 100 selon l'invention.

Le procédé 100 selon l'invention vise à déterminer un seuil applicable pour déterminer la dimension critique d'un motif appartenant à au moins une catégorie de motifs (trous, plots, ligne, tranchée,..) imagés par microscopie électronique à force atomique à balayage. Le matériau du motif peut être quelconque.

Ce motif peut être par exemple un motif isolé ou appartenant à un réseau de motifs répétés périodiquement. Il peut s'agir d'un motif obtenu après n'importe quelle étape (lithographie, gravure,...) d'un procédé de fabrication.

Nous illustrerons la mise en oeuvre du procédé 100 dans le cas de motifs tels que le motif (plot) M représenté en figure 6.

Ce procédé 100 comporte les étapes suivantes :

- à partir d'une pluralité de motifs (tels que le motif M de la figure 6), acquisition 101 d'un couple d'images IM1, IM2 pour chaque motif M :
- une première image IM1 est obtenue au moyen d'une instrumentation d'imagerie mettant en oeuvre la technique de microscopie électronique à force atomique à balayage, dite instrumentation CD-SEM, dont on cherche à déterminer le seuil (i.e. le seuil applicable) ;
- une deuxième image IM2 est obtenue au moyen d'une instrumentation d'imagerie de référence mettant en oeuvre une technique différente de la technique de microscopie électronique à balayage, par exemple la microscopie à force atomique en trois dimensions (ou CD-AFM pour « Critical Dimension - Atomic Force Microscopy » en anglais);
- pour chaque couple d'images IM1, IM2 obtenu pour chacun des motifs M :

  ■ détermination 102 d'une dimension critique de référence $CD_{REF}$ via l'image IM2 obtenue au moyen de l'instrumentation d'imagerie de référence ;

    ○ détermination 103 d'un seuil empirique $S_{EMP}$ applicable à l'image IM1 obtenue au moyen de l'instrumentation CD-SEM de sorte que le seuil empirique $S_{EMP}$ corresponde sensiblement à la dimension critique de référence $CD_{REF}$ déterminée lors de l'étape précédente 102,
    ○ détermination 104 d'un seuil S applicable à au moins une catégorie de motifs M, le seuil S étant déterminé à partir de la pluralité de seuils empiriques $S_{EMP}$, chaque seuil empirique $S_{EMP}$ correspondant à un couple d'images.

L'opération consistant à déterminer un seuil empirique $S_{EMP}$ est répétée sur une pluralité de motifs i (i variant de 1 à n, n étant le nombre de motifs utilisés pour la mise en oeuvre du procédé) pour lesquels on utilise à chaque fois un couple d'images. Dans la suite de la description, on désignera par $S_{EMP}(i)$ le seuil empirique déterminé pour le couple d'images du motif i.

Comme évoqué plus haut, l'étape 101 consiste à réaliser pour chaque motif i :

- une première image IM1 (i) du contour du motif i obtenue au moyen d'une instrumentation d'imagerie de type CD-SEM ; chaque image IM1 (i) est ensuite enregistrée dans une matrice d'images ;
- une deuxième image IM2(i) du contour du motif obtenue au moyen d'une technique d'imagerie de référence, par exemple la microscopie à force atomique en trois dimensions (ou CD-AFM pour « Critical Dimension - Atomic Force Microscopy » en anglais), ou la microscopie électronique en transmission (ou TEM pour «Transmission Electron Microscopy » en anglais), cette technique d'imagerie de référence étant plus précise que la CD-SEM. On pourrait également utiliser la scatterométrie pour réaliser la deuxième image IM2(i). Cette image IM2(i) permet de fournir une image en coupe précise du motif dont on chercher la déterminer la dimension critique ; chaque image IM2(i) est ensuite enregistrée dans une matrice d'images.

L'étape 102 consiste, pour chaque motif i, à déterminer une dimension critique de référence $CD_{REF}(i)$ via l'image obtenue au moyen de l'instrumentation d'imagerie de référence.

L'étape 103 consiste, pour chaque motif i, à déterminer un seuil empirique $S_{EMP}(i)$ applicable à l'image IM1(i) obtenue au moyen de l'instrumentation CD-SEM de sorte que le seuil empirique $S_{EMP}(i)$ corresponde sensiblement voire exactement à la dimension critique de référence $CD_{REF}(i)$. Plus précisément, la figure 3 illustre un profil d'intensité d'électrons secondaires PI d'un motif i imagé au moyen de la technique d'imagerie CD-SEM, le profil d'intensité PI étant par exemple dessiné via un programme utilisé pour effectuer des mesures par CD-SEM bien connu de l'homme du métier. L'axe des ordonnées représente un pourcentage d'électrons secondaires et l'axe des abscisses représente une dimension en nm. Ainsi, pour une dimension critique de référence $CD_{REF}(i)$ déterminée au moyen de la technique d'imagerie de référence on en déduit un seuil empirique $S_{EMP}(i)$ correspondant sensiblement à la dimension critique de référence $CD_{REF}(i)$. Dans l'exemple illustré, pour une dimension critique de référence $CD_{REF}(i)$ de 2nm, le seuil empirique $S_{EMP}(i)$ correspondant est de 30% d'électrons secondaires.

L'étape 104 consiste à déterminer un seuil S applicable à au moins une catégorie de motifs, ce seuil S étant déterminé à partir de la pluralité de seuils empiriques $S_{EMP}(i)$ obtenus précédemment pour chaque motif i, chaque seuil empirique $S_{EMP}(i)$ correspondant à un couple d'images IM1, IM2 correspondant au motif i. Le seuil S applicable à au moins une catégorie de motif pouvant être :

- un seuil constant $S_{CTR}$ applicable à toutes les catégories de motifs, ou
- un seuil variable $S_{VTR}$ applicable à une catégorie de motifs.

Comme illustré sur la figure 4, selon un premier mode de réalisation de l'invention, l'étape 104 de détermination d'un seuil peut être réalisée selon une première approche consistant à déterminer un seuil constant $S_{CTR}$ applicable à toutes les catégories de motifs.

Dans ce cas, pour déterminer le seuil constant $S_{CTR}$, on choisi une valeur seuil fixe (par exemple 80%) et on détermine des mesures de CD à partir des images IM1 obtenues par CD-SEM sur une pluralité de motifs de catégories différentes. Ensuite on détermine ce seuil constant $S_{CTR}$ en minimisant 104a l'écart entre ces valeurs de CD mesurées par CD-SEM et les valeurs de CD mesurées par la technique d'imagerie de référence, les valeurs de CD étant contenues dans les matrices d'images. En d'autres termes, on détermine le seuil constant en minimisant l'écart entre le seuil constant $S_{CTR}$ et les différents seuils empiriques $S_{EMP}(i)$ nous permettant d'approcher les mesures de CD de référence. L'écart entre le seuil constant $S_{CTR}$ et chacun des seuils empiriques $S_{EMP}(i)$ est minimisé 104a, par exemple en utilisant une méthode consistant à minimiser l'erreur quadratique RMS via la formule suivante :

$$\text{RMS Error} = \frac{\sqrt{\sum_{images-CDSEM} w(i)(S_{CTR} - S_{EMP}(i))^2}}{\sqrt{\sum_{images-CDSEM} w(i)}}$$

Où :

- w(i) est un coefficient de pondération attribué à la mesure (i), le poids dépendant de l'expérience de l'utilisateur et de l'importance que l'on souhaite donner à l'image et donc à la catégorie de motif,
- $S_{CTR}$ est le seuil constant, et
- $S_{EMP}(i)$ est le seuil empirique calculé pour la mesure (i).

Le seuil constant ainsi calculé est ensuite applicable en recherche et développement ou en production sur chaque motif imagé par CD-SEM. Plus particulièrement, le seuil constant est applicable à toutes les catégories de motif, quelles que soient leurs géométries, par exemple pour des plots, des tranchées ou encore des lignes.

Comme illustrée sur la figure 5, selon un deuxième mode de réalisation de l'invention, l'étape 104 de détermination d'un seuil peut être réalisée selon une approche différente consistant à déterminer un seuil variable $S_{VTR}$ applicable à une unique catégorie de motif ou une pluralité de catégories de motifs.

Dans le cas d'une unique catégorie de motif, un seuil variable $S_{VTR}$ est déterminé pour chaque catégorie de motif. Il convient de noter que cette deuxième approche est plus précise que celle du seuil constant présentée précédemment en relation avec la figure 4.

Le seuil variable $S_{VTR}$ est déterminé en :

- calculant 104b un seuil variable empirique $S_{VTRE}(i)$ pour chaque image de référence IM2(i) d'une même catégorie de motifs, n images IM2(i) (avec i variant de 1 à n) étant réalisées sur m motifs de la même catégorie,
- minimisant 104c l'écart entre le seuil variable $S_{VTR}$ et chacun des seuils variables empiriques $S_{VTRE}(i)$.

Selon ce second mode de réalisation, pour déterminer un seuil variable empirique $S_{VTRE}(i)$, plusieurs paramètres en sus de la dimension critique CD sont pris en compte, par exemple l'angle SWA formé entre le flanc du motif M et le substrat S ou encore la hauteur h du motif M (Cf. figure 6). Il est entendu que d'autres paramètres peuvent être pris en compte sans pour autant sortir du cadre de l'invention. En d'autres termes, $S_{VTRE}(i)$ est une fonction de trois paramètres (ici le CD, l'angle SWA et la hauteur h). Cela permet d'être plus juste au final car l'approche est une approche de réduction de l'incertitude globale

On calcule donc un seuil variable empirique $S_{VTRE}(i)$ pour chaque image IM2(i) d'une même catégorie de motifs (par exemple des plots) obtenue via la technique d'imagerie de référence, n images IM2(i) (i variant de 1 à n) étant réalisées via l'imagerie de référence sur m plots. De façon non limitative, ce seuil variable empirique $S_{VTRE}(i)$ peut être calculé via un polynôme de second degré conforme à celui-ci-dessous :

$$S_{VTRE}(i) = C_0 + C_1 CD_{REF} + C_2 SWA_{REF} + C_3 H_{REF} + C_4 CD^2_{REF} + C_5 SWA +$$

$$C_6 H^2_{REF} + C_7 CD_{REF} SWA_{REF} + C_8 CD_{REF} H_{REF} + C_9 H_{REF} SWA_{REF}$$

Il convient de noter que le polynôme est préférentiellement de second degré mais peut être de degré supérieur. En outre, les trois variables ne sont pas limitatives et d'autres variables peuvent êtres utilisées.

Dans une réalisation non limitative le coefficient $C_0$ est égal au seuil constant $S_{CTR}$. Dans ce cas, le coefficient $C_0$ égal au seuil constant $S_{CTR}$ est déterminé en minimisant 104a l'écart entre le seuil constant $S_{CTR}$ et chacun des seuils empiriques $S_{EMP}(i)$ conformément au premier mode de réalisation de l'invention précédemment décrit et illustré au moyen de la figure 4.

Dans un autre mode de réalisation, le coefficient $C_0$ est fixé de manière arbitraire, par exemple 80%. Ce coefficient $C_0$ peut également être calculé de manière différente.

Pour résoudre le polynôme de second degré précité, on cherche à optimiser les coefficients $C_k$ (k variant de 1 à m). L'optimisation des coefficients $C_k$ s'effectue par la résolution du système linéaire ci-dessous à n équations (nombre des mesures) et m inconnues (nombre des coefficients $C_k$ à optimiser, i.e m=9 dans l'exemple) :

$$\begin{pmatrix} CD^{(1)}_{REF} .... H^{(1)}_{REF} SWA^{(1)}_{REF} \\ \vdots \quad \ddots \quad \vdots \\ CD^{(n)}_{REF} .... H^{(n)}_{REF} SWA^{(n)}_{REF} \end{pmatrix} \begin{pmatrix} C_1 \\ \vdots \\ C_m \end{pmatrix} = \begin{pmatrix} S^{(1)}_{EMP} - C_0 \\ \vdots \\ S^{(n)}_{EMP} - C_0 \end{pmatrix}$$

On obtient ainsi une pluralité de seuil variable empirique $S_{VTRE}(i)$, chacun des seuils variables empiriques $S_{VTRE}(i)$ correspondant à une image d'un motif et la pluralité de motifs appartenant à une même catégorie (des plots dans l'exemple).

Ensuite, on cherche à minimiser 104c l'écart entre le seuil variable à déterminer $S_{VTR}$ et chacun des seuils variables empiriques $S_{VTRE}(i)$ nous permettant d'approcher les mesures de CD de référence. L'écart entre le seuil variable $S_{VTR}$ (i.e. variable en fonction de la catégorie de motifs) et chacun des seuils variables empiriques $S_{VTRE}(i)$ est minimisé 104c par exemple en utilisant une méthode consistant à minimiser l'erreur quadratique RMS via la formule suivante :

$$\text{RMS Error} = \frac{\sqrt{\sum_{images-CDSEM} w(i)(S_{VTR} - S_{VTRE}(i))^2}}{\sqrt{\sum_{images-CDSEM} w(i)}}$$

- $w(i)$ est un coefficient de pondération attribué à la mesure (i), le poids dépendant de l'expérience de l'utilisateur et de l'importance que l'on souhaite donner à l'image et donc à la catégorie de motif,
- $S_{VTR}$ est le seuil variable, et
- $S_{VTRE}(i)$ est le seuil variable empirique calculé pour la mesure (i).

Le seuil variable ainsi calculé pour une catégorie de motifs est ensuite applicable en recherche et développement ou en production sur chaque motif de cette catégorie imagé par CD-SEM.

Il est entendu que l'invention n'est pas limitée au mode de réalisation qui vient d'être décrit, et notamment en ce qui concerne le calcul du seuil variable empirique.

Ainsi, même si chacun des seuils variables empiriques a été déterminé via une fonction de second ordre prenant en compte une dimension critique, un angle et une hauteur, il est entendu que tout autre type fonction et/ou de paramètres peuvent être utilisés sans pour autant sortir du cadre de l'invention.

En outre, comme indiqué précédemment, l'étape 104 de détermination d'un seuil peut consister à déterminer un seuil variable $S_{VTR}$ applicable à une pluralité de catégories de motifs, par exemple pour un même niveau de grille. Dans ce cas, le seuil variable est déterminé dans un premier temps à l'étape gravure et dans un second temps à l'étape lithographie.

## Revendications

1.  Procédé (100) de détermination d'un seuil applicable pour déterminer la dimension critique (CD) d'au moins une catégorie de motifs (M) imagés par microscopie électronique à force atomique à balayage, ledit procédé (100) comportant les étapes suivantes :

    - à partir d'une pluralité de motifs (M), acquisition (101) d'un couple d'images (IM1, IM2) pour chaque motif (M) :

        ○ une première image (IM1) étant obtenue au moyen d'une instrumentation d'imagerie mettant en oeuvre la technique de microscopie électronique à force atomique à balayage, dite instrumentation CD-SEM, dont on cherche à déterminer ledit seuil ;
        ○ une deuxième image (IM2) étant obtenue au moyen d'une instrumentation d'imagerie de référence mettant en oeuvre une technique différente de ladite technique de microscopie électronique à balayage ;
        ○ pour chaque couple d'images (IM1, IM2) obtenu pour chacun des motifs (M) :

            ■ détermination (102) d'une dimension critique ($CD_{REF}$) de référence via l'image (IM2) obtenue au moyen de ladite instrumentation d'imagerie de référence ;
            ■ détermination (103) d'un seuil empirique ($S_{EMP}$) applicable à l'image (IM1) obtenue au moyen de ladite instrumentation CD-SEM de sorte que ledit seuil empirique ($S_{EMP}$) corresponde sensiblement à ladite dimension critique de référence ($CD_{REF}$);

    - détermination (104) du seuil (S) applicable à au moins une catégorie de motifs (M), ledit seuil (S) étant déterminé à partir d'une pluralité de seuils empiriques ($S_{EMP}$), chaque seuil empirique correspondant à un couple d'images.

2.  Procédé (100) selon la revendication 1 **caractérisé en ce que** le seuil (S) est un seuil constant ($S_{CTR}$) applicable à toutes les catégories de motifs.

3.  Procédé (100) selon la revendication 2 **caractérisé en ce que** le seuil constant ($S_{CTR}$) est déterminé en minimisant (104a) l'écart entre le seuil constant ($S_{CTR}$) et chacun des seuils empiriques ($S_{EMP}(i)$).

4.  Procédé (100) selon la revendication 3 **caractérisé en ce que** l'écart entre le seuil constant ($S_{CTR}$) et chacun des seuils empiriques ($S_{EMP}(i)$) est minimisé (104a) en utilisant une méthode consistant à minimiser l'erreur quadratique RMS.

5.  Procédé (100) selon la revendication 1 **caractérisé en ce que** le seuil (S) est un seuil variable ($S_{VTR}$) fonction de la catégorie de motifs (M).

6.  Procédé (100) selon la revendication 5 **caractérisé en ce que** le seuil variable ($S_{VTR}$) est déterminé en :

    - calculant (104b) un seuil variable empirique ($S_{VTRE}(i)$) pour chaque image de référence (IM2(i)) d'une même catégorie de motifs, n images (IM2) étant réalisées sur m motifs de ladite même catégorie,
    - minimisant (104c) l'écart entre le seuil variable ($S_{VTR}$) et chacun des seuils variables empiriques ($S_{VTRE}(i)$) calculés.

7.  Procédé (100) selon la revendication 6 **caractérisé en ce que** chaque seuil variable empirique ($S_{VTRE}(i)$) est une fonction de la dimension critique de référence ($CD_{REF}$) de la catégorie de motifs, d'une hauteur de référence ($SWE_{REF}$) et/ou d'un angle de référence ($H_{REF}$) de ladite catégorie de motifs.

8.  Procédé (100) selon la revendication 7 **caractérisé en ce que** ladite fonction est un polynôme de second degré.

9.  Procédé (100) selon les revendications 2 à 4 et 8 **caractérisé en ce que** le polynôme de second degré comporte

un coefficient constant ($C_0$) égal au seuil constant ($S_{CTR}$).

10. Procédé (100) selon l'une des revendications 6 à 9 **caractérisé en ce que** l'écart entre le seuil variable ($S_{VTR}$) et chacun des seuils variables empiriques ($S_{VTRE}(i)$) est minimisé (104c) en utilisant une méthode consistant à minimiser l'erreur quadratique RMS.

11. Procédé (100) selon l'une des revendications précédentes **caractérisé en ce que** l'instrumentation d'imagerie de référence met en oeuvre l'une des techniques suivantes :

    - microscopie à force atomique en trois dimensions, ou
    - microscopie électronique en transmission.

(%)

100

80

PI

0

CD

(nm)

**Fig. 1**

100

101

IM1    IM2

S_EMP  ≈  CD_REF ← 102

103

104    S

**Fig. 2**

(%)

100

PI

30

0

2

(nm)

**Fig. 3**

104    S

-104a-

**Fig. 4**

S

-104a- ← 104

-104b-

-104c-

**Fig. 5**

h    M

CD

S    SWE

**Fig. 6**

# EP 2 660 778 A1

**Europäisches Patentamt**
**European Patent Office**
**Office européen des brevets**

## RAPPORT DE RECHERCHE EUROPEENNE

Numéro de la demande

EP 13 16 6025

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | J. FOUCHER ET AL: "Hybrid metrology for critical dimension based on scanning methods for IC manufacturing", PROCEEDINGS OF SPIE, vol. 8378, 23 avril 2012 (2012-04-23), pages 83780F-83780F-8, XP055041281, ISSN: 0277-786X, DOI: 10.1117/12.919650 * figure 5 * * figure 6 * * figure 7 * * figure 9 * * Section 3 * ----- | 1-11 | INV. G06T7/00 |
| Y | DATABASE INSPEC [Online] THE INSTITUTION OF ELECTRICAL ENGINEERS, STEVENAGE, GB; 2011, VAID A ET AL: "A holistic metrology approach: hybrid metrology utilizing scatterometry, CD-AFM, and CD-SEM", XP002685430, Database accession no. 11992127 * abrégé * & METROLOGY, INSPECTION, AND PROCESS CONTROL FOR MICROLITHOGRAPHY XXV 28 FEB.-3 MARCH 2011 SAN JOSE, CA, USA, vol. 7971, 28 février 2011 (2011-02-28), - 3 mars 2011 (2011-03-03), Proceedings of the SPIE - The International Society for Optical Engineering SPIE - The International Society for Optical Engineering USA ISSN: 0277-786X, DOI: DOI:10.1117/12.881632 ----- | 1-11 | |
| Y | US 2005/197772 A1 (ARCHIE CHARLES N [US] ET AL) 8 septembre 2005 (2005-09-08) * le document en entier * ----- -/-- | 1-11 | **DOMAINES TECHNIQUES RECHERCHES (IPC)** G06T |

Le présent rapport a été établi pour toutes les revendications

| Lieu de la recherche | Date d'achèvement de la recherche | Examinateur |
|---|---|---|
| Munich | 24 mai 2013 | Leclercq, Philippe |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

10

Europäisches
Patentamt

European
Patent Office

Office européen
des brevets

# RAPPORT DE RECHERCHE EUROPEENNE

Numéro de la demande

EP 13 16 6025

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | WO 2004/059247 A1 (IBM CORP) 15 juillet 2004 (2004-07-15) * le document en entier * ----- | 1-11 | |
| Y | US 6 392 229 B1 (DANA STEPHANE [IL] ET AL) 21 mai 2002 (2002-05-21) * le document en entier * ----- | 1-11 | |
| Y | ORJI N G ET AL: "A Systematic Approach to Accurate Evaluation of CD-Metrology Tools", MICROELECTRONIC TEST STRUCTURES, 2007. ICMTS '07. IEEE INTERNATIO NAL CONFERENCE ON, IEEE, PI, 1 mars 2007 (2007-03-01), pages 9-13, XP031181049, DOI: 10.1109/ICMTS.2007.374446 ISBN: 978-1-4244-0780-4 * le document en entier * ----- | 1-11 | |
| A | DATABASE INSPEC [Online] THE INSTITUTION OF ELECTRICAL ENGINEERS, STEVENAGE, GB; 2003, SENDELBACH M ET AL: "Scatterometry measurement precision and accuracy below 70 nm", XP002685431, Database accession no. 7793603 * abrégé * -/-- | 1-11 | DOMAINES TECHNIQUES RECHERCHES (IPC) |

Le présent rapport a été établi pour toutes les revendications

| Lieu de la recherche | Date d'achèvement de la recherche | Examinateur |
|---|---|---|
| Munich | 24 mai 2013 | Leclercq, Philippe |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons

& : membre de la même famille, document correspondant

EPO FORM 1503 03.82 (P04C02)

Europäisches
Patentamt

European
Patent Office

Office européen
des brevets

# RAPPORT DE RECHERCHE EUROPEENNE

Numéro de la demande

EP 13 16 6025

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | & METROLOGY, INSPECTION, AND PROCESS CONTROL FOR MICROLITHOGRAPHY XVII 24-27 FEB. 2003 SANTA CLARA, CA, USA, vol. 5038, 24 février 2003 (2003-02-24), - 27 février 2003 (2003-02-27), pages 224-238, Proceedings of the SPIE - The International Society for Optical Engineering SPIE-Int. Soc. Opt. Eng. USA ISSN: 0277-786X, DOI: DOI:10.1117/12.488117 ----- | 1-11 | |
| A | KNIGHT S ET AL: "Advanced metrology needs for nanoelectronics lithography", COMPTES RENDUS - PHYSIQUE, ELSEVIER, PARIS, FR, vol. 7, no. 8, 1 octobre 2006 (2006-10-01) , pages 931-941, XP024978771, ISSN: 1631-0705, DOI: 10.1016/J.CRHY.2006.10.004 [extrait le 2006-10-01] * le document en entier * ----- | 1-11 | |
| A | DATABASE INSPEC [Online] THE INSTITUTION OF ELECTRICAL ENGINEERS, STEVENAGE, GB; 2007, ZANGOOIE S ET AL: "Characterization of capacitive 3D deep trench mask open structures using scatterometry", XP002685432, Database accession no. 10329208 * abrégé *  -/-- | 1-11 | |

DOMAINES TECHNIQUES RECHERCHES (IPC)

Le présent rapport a été établi pour toutes les revendications

| Lieu de la recherche | Date d'achèvement de la recherche | Examinateur |
|---|---|---|
| Munich | 24 mai 2013 | Leclercq, Philippe |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

# EP 2 660 778 A1

**RAPPORT DE RECHERCHE EUROPEENNE**

Numéro de la demande

EP 13 16 6025

Europäisches Patentamt
European Patent Office
Office européen des brevets

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| | & METROLOGY, INSPECTION, AND PROCESS CONTROL FOR MICROLITHOGRAPHY XXI 26 FEB. 2007 SAN JOSE, CA, USA, vol. 6518, 26 février 2007 (2007-02-26), Proceedings of the SPIE - The International Society for Optical Engineering SPIE - The International Society for Optical Engineering USA ISSN: 0277-786X, DOI: DOI:10.1117/12.712763<br>----- | | |

**DOMAINES TECHNIQUES RECHERCHES (IPC)**

Le présent rapport a été établi pour toutes les revendications

| Lieu de la recherche | Date d'achèvement de la recherche | Examinateur |
|---|---|---|
| Munich | 24 mai 2013 | Leclercq, Philippe |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.........................................................................

& : membre de la même famille, document correspondant

EPO FORM 1503 03.82 (P04C02)

13

**ANNEXE AU RAPPORT DE RECHERCHE EUROPEENNE
RELATIF A LA DEMANDE DE BREVET EUROPEEN NO.**

EP 13 16 6025

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

24-05-2013

| Document brevet cité au rapport de recherche | Date de publication | Membre(s) de la famille de brevet(s) | Date de publication |
|---|---|---|---|
| US 2005197772 A1 | 08-09-2005 | US 2005197772 A1<br>US 2005222804 A1 | 08-09-2005<br>06-10-2005 |
| WO 2004059247 A1 | 15-07-2004 | AU 2002364215 A1<br>CN 1695040 A<br>EP 1573268 A1<br>JP 4272624 B2<br>JP 2006510912 A<br>US 2008140342 A1<br>WO 2004059247 A1 | 22-07-2004<br>09-11-2005<br>14-09-2005<br>03-06-2009<br>30-03-2006<br>12-06-2008<br>15-07-2004 |
| US 6392229 B1 | 21-05-2002 | AUCUN | |

EPO FORM P0460

Pour tout renseignement concernant cette annexe : voir Journal Officiel de l'Office européen des brevets, No.12/82